(19) Europäisches Patentamt
European Patent Office
Office européen des brevets

(11) EP 2 053 107 A1

(12) **EUROPEAN PATENT APPLICATION**
published in accordance with Art. 153(4) EPC

(43) Date of publication:
**29.04.2009 Bulletin 2009/18**

(21) Application number: **07792500.6**

(22) Date of filing: **14.08.2007**

(51) Int Cl.:
***C09D 183/00*** *(2006.01)* ***C23C 16/06*** *(2006.01)*
***H01L 21/312*** *(2006.01)*

(86) International application number:
**PCT/JP2007/065857**

(87) International publication number:
**WO 2008/020592 (21.02.2008 Gazette 2008/08)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **15.08.2006 JP 2006221402**
**28.02.2007 JP 2007049168**

(71) Applicant: **JSR Corporation**
**Tokyo 104-8410 (JP)**

(72) Inventors:
- **AKIYAMA, Masahiro**
  **Chuo-ku**
  **Tokyo 104-8410 (JP)**
- **NAKAGAWA, Hisashi**
  **Chuo-ku**
  **Tokyo 104-8410 (JP)**
- **KOKUBO, Terukazu**
  **Chuo-ku**
  **Tokyo 104-8410 (JP)**

(74) Representative: **TBK-Patent**
**Bavariaring 4-6**
**80336 München (DE)**

(54) **FILM-FORMING MATERIAL, SILICON-CONTAINING INSULATING FILM AND METHOD FOR FORMING THE SAME**

(57) A silicon-containing film-forming material including an organosilane compound shown by the following general formula (1),

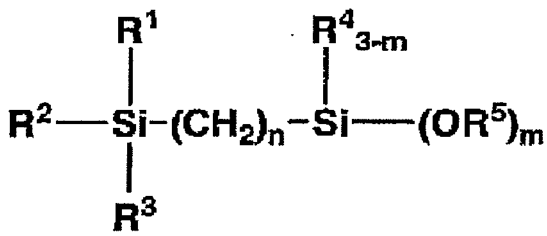

(1)

wherein $R^1$ to $R^4$ individually represent a hydrogen atom, an alkyl group having 1 to 4 carbon atoms, a vinyl group, or a phenyl group, $R^5$ represents an alkyl group having 1 to 4 carbon atoms, an acetyl group, or a phenyl group, n represents an integer from 1 to 3, and m represents 1 or 2.

EP 2 053 107 A1

## Description

TECHNICAL FIELD

The present invention relates to a film-forming material, a silicon-containing insulating film, and a method of forming the same.

BACKGROUND ART

In recent years, an increase in processing speed has been strongly desired for ultra-large scale integrated (ULSI) circuits in order to deal with an increase in the processing of target information and the degree of functional complexity. An increase in ULSI processing speed has been implemented by reducing the size of elements provided in a chip, increasing the degree of integration of elements, and forming a multi-layer film. However, an increase in wiring resistance and wiring parasitic capacitance occurs due to a reduction in size of elements so that a wire delay predominantly causes a signal delay of the entire device. In order to solve this problem, it is indispensable to use a low-resistivity wiring material or a low-dielectric-constant (low-k) interlayer dielectric material.

As a wiring material, Cu that has a low resistivity has been studied and used instead of Al. As an interlayer dielectric material, a silica ($SiO_2$) film formed by a vacuum process such as chemical vapor deposition (CVD) has been widely used. Various proposals have been made to form a low-dielectric-constant (low-k) interlayer dielectric.

Examples of the low-dielectric-constant interlayer dielectric include a porous silica film formed by reducing the film density of silica ($SiO_2$), an inorganic interlayer dielectric such as a silica film doped with F (FSG) and an SiOC film doped with C, and an organic interlayer dielectric such as a polyimide, polyarylene, and polyarylene ether.

A coating-type insulating film (SOG film) that contains a hydrolysis-condensation product of a tetraalkoxysilane as the main component, and an organic SOG film formed of a polysiloxane obtained by hydrolysis and condensation of an organic alkoxysilane, have also been proposed in order to form a more uniform interlayer dielectric.

An interlayer dielectric is formed as follows. An interlayer dielectric is generally formed by a coating method (spin coating method) or chemical vapor deposition (CVD). The coating method forms a film by applying an insulating film-forming polymer solution using a spin coater or the like, and CVD introduces a reaction gas into a chamber and deposits a film utilizing a gas-phase reaction.

An inorganic material and an organic material have been proposed for the coating method and CVD. A film with excellent uniformity is generally obtained by the coating method. However, a film obtained by the coating method may exhibit inferior adhesion to a substrate or a barrier metal. A film obtained by CVD may exhibit poor uniformity or a dielectric constant that is not sufficiently reduced. On the other hand, an interlayer dielectric deposited by CVD has been widely used due to an operational advantage and excellent adhesion to a substrate. Therefore, CVD has an advantage over the coating method.

Various films obtained by CVD have been proposed. In particular, various films characterized by a silane compound used for a reaction have been proposed. For example, a film obtained using a dialkoxysilane (JP-A-11-288931 and JP-A-2002-329718), a film obtained using a cyclic silane compound (JP-T-2002-503879 and JP-T-2005-513766), and a film obtained using a silane compound in which a tertiary carbon atom or a secondary carbon atom is bonded to Si (JP-A-2004-6607 and JP-A-2005-51192) have been disclosed. A film having a low dielectric constant and excellent adhesion to a barrier metal or the like may be obtained using such a material.

However, such a silane compound may require extreme conditions during deposition by CVD due to chemical stability, or may undergo a reaction in a pipe connected to a chamber due to chemical instability, or may exhibit poor storage stability. A deposited insulating film may exhibit high hygroscopicity depending on the selected compound so that a leakage current may increase. A semiconductor device production process generally involves a step that processes an interlayer dielectric using reactive ion etching (RIE). The dielectric constant of a film may increase during RIE, or an interlayer dielectric may be damaged by a hydrofluoric acid-based chemical used in the subsequent washing step. Therefore, an interlayer dielectric having high process resistance has been desired.

DISCLOSURE OF THE INVENTION

An object of the invention is to provide a silicon-containing film-forming material that can be suitably used for semiconductor devices for which an increase in degree of integration and the number of layers has been desired, is chemically stable but is suitable for CVD, and can form an interlayer dielectric having excellent mechanical strength, a low relative dielectric constant, low hygroscopicity, and high process resistance.

Another object of the invention is to provide a silicon-containing insulating film having excellent mechanical strength, a low relative dielectric constant, low hygroscopicity, and high process resistance, and a method of forming the same.

The inventors of the invention found that an organosilane compound that has a silicon-carbon-silicon skeleton and has a specific structure in which oxygen is bonded to one of the silicon atoms is chemically stable but is suitable for CVD, and an interlayer dielectric material having a low relative dielectric constant, low hygroscopicity, and high process resistance can be obtained using the organosilane compound.

According to one aspect of the invention, there is provided a silicon-containing film-forming material comprising an organosilane compound shown by the following general formula (1),

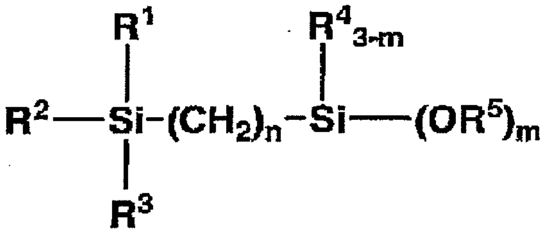

(1)

wherein $R^1$ to $R^4$ individually represent a hydrogen atom, an alkyl group having 1 to 4 carbon atoms, a vinyl group, or a phenyl group, $R^5$ represents an alkyl group having 1 to 4 carbon atoms, an acetyl group, or a phenyl group, n represents an integer from 1 to 3, and m represents 1 or 2.

The silicon-containing film-forming material may be used to form an insulating film that includes silicon, carbon, oxygen, and hydrogen.

The silicon-containing film-forming material may have a content of elements other than silicon, carbon, oxygen, and hydrogen of less than 10 ppb, and a water content of less than 100 ppm.

According to one aspect of the invention, there is provided a silicon-containing insulating film formed by using the above-described silicon-containing film-forming material.

The silicon-containing insulating film may be formed by chemical vapor deposition.

According to a third aspect of the invention, there is provided a method of forming a silicon-containing insulating film, the method comprising:

depositing the above-described silicon-containing film-forming material on a substrate by chemical vapor deposition to form a deposited film; and
curing the deposited film by at least one means selected from heating, electron beam irradiation, ultraviolet irradiation, and oxygen plasma application.

According to a fourth aspect of the invention, there is provided a silicon-containing insulating film obtained by the above-described method of forming a silicon-containing insulating film.

The silicon-containing insulating film may include an $-Si-(CH_2)_n-Si-O-$ site (wherein n represents an integer from 1 to 3).

The silicon-containing insulating film may have a dielectric constant of 3.0 or less.

Since the above silicon-containing film-forming material includes the organosilane compound shown by the general formula (1), the silicon-containing film-forming material can be suitably used for semiconductor devices for which an increase in degree of integration and the number of layers has been desired, is chemically stable but is suitable for CVD, and can be used to form an interlayer dielectric having excellent mechanical strength, a low relative dielectric constant, low hygroscopicity, and high process resistance. In the organosilane compound shown by the general formula (1), all of the substituents of one silicon atom and one or two substituents of the other silicon atom are replaced by a hydrogen atom, an alkyl group having 1 to 4 carbon atoms, a vinyl group, or a phenyl group, and the oxygen atom is bonded to only one or two substituents of one silicon atom. It is considered that the $R^1R^2R^3-Si-(CH_2)_n-Si-R$ site of the organosilane compound shown by the general formula (1) reduces damage due to RIE and increases resistance to a hydrofluoric acid-based chemical. Since the $-Si-(OR^5)_m$ site forms an -Si-O-Si- bond to form a three-dimensional skeleton with a high degree of crosslinking, an insulating film having excellent mechanical strength, a low relative dielectric constant, and high process resistance can be obtained.

The above silicon-containing insulating film has excellent mechanical strength, a low relative dielectric constant, and high process resistance.

According to the above method of forming a silicon-containing insulating film, an insulating film having excellent

mechanical strength, a low relative dielectric constant, and high process resistance can be obtained.

The above silicon-containing insulating film has excellent mechanical strength, a low relative dielectric constant, and high process resistance.

According to the above method of forming a silicon-containing insulating film, an insulating film having excellent mechanical strength, a low relative dielectric constant, and high process resistance can be obtained.

BEST MODE FOR CARRYING OUT THE INVENTION

The invention is described in detail below.

1. Silicon-containing film-forming material and method of producing the same

1.1. Silicon-containing film-forming material

According to one embodiment of the invention, there is provided a silicon-containing film-forming material comprising an organosilane compound shown by the following general formula (1),

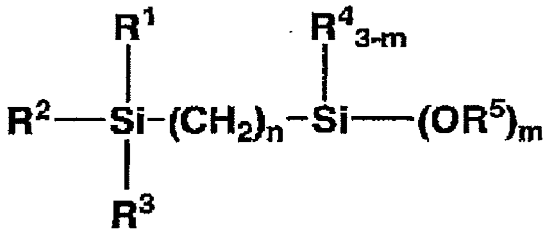

(1)

wherein $R^1$ to $R^4$ individually represent a hydrogen atom, an alkyl group having 1 to 4 carbon atoms, a vinyl group, or a phenyl group, $R^5$ represents an alkyl group having 1 to 4 carbon atoms, an acetyl group, or a phenyl group, n represents an integer from 1 to 3, and m represents 1 or 2.

In the general formula (1), $R^1$ to $R^4$ individually represent a hydrogen atom, an alkyl group having 1 to 4 carbon atoms, a vinyl group, or a phenyl group. Examples of the alkyl group having 1 to 4 carbon atoms include a methyl group, an ethyl group, an n-propyl group, an isopropyl group, an n-butyl group, an isobutyl group, a tert-butyl group, and the like. A methyl group, a vinyl group, and a hydrogen atom are particularly preferable as $R^1$ to $R^4$.

In the general formula (1), $R^5$ represents an alkyl group having 1 to 4 carbon atoms, an acetyl group, or a phenyl group. Examples of the alkyl group having 1 to 4 carbon atoms include the alkyl groups mentioned for $R^1$ to $R^4$. A methyl group and an ethyl group are particularly preferable as $R^5$.

In the general formula (1), n represents an integer from 1 to 3, and n represents 1 or 2.

Examples of the organosilane compounds shown by the general formula (1) in which n=1 and m=1 include the following compounds.

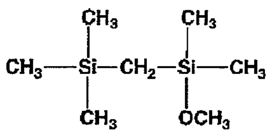

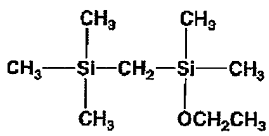

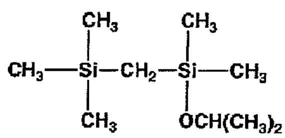

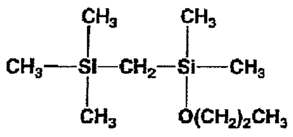
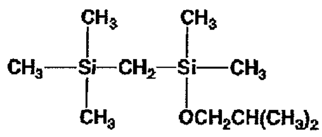
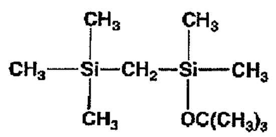

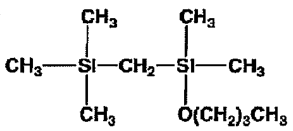
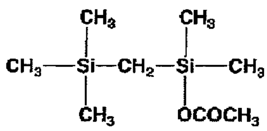
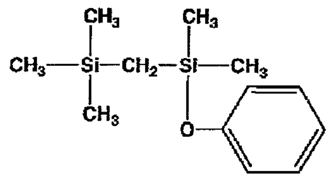

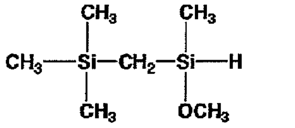
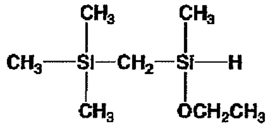
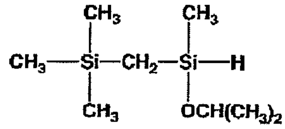

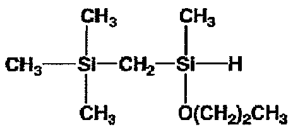
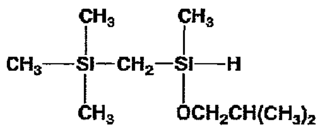
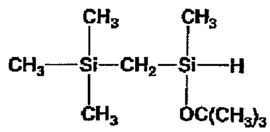

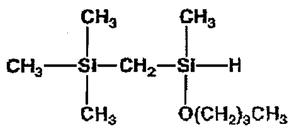
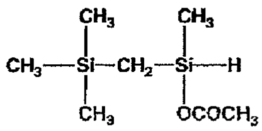
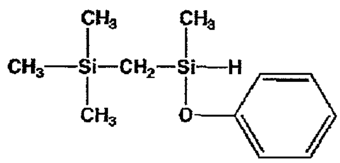

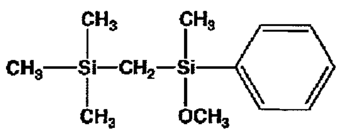
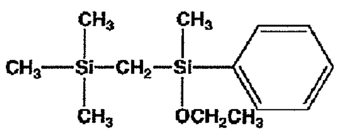
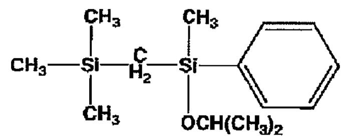

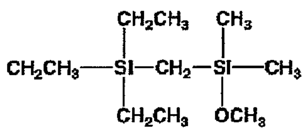
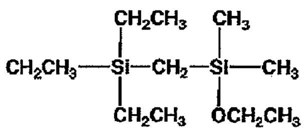
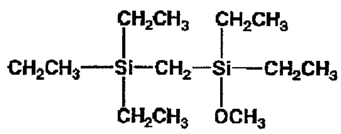

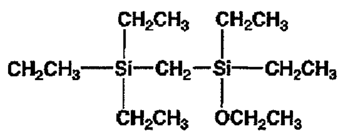
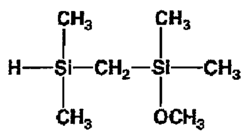
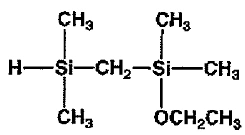

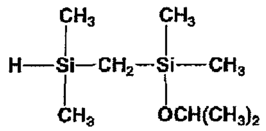
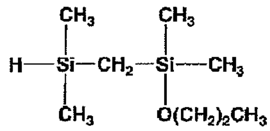
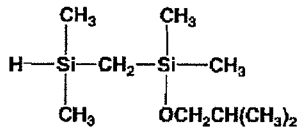
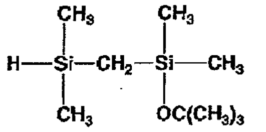
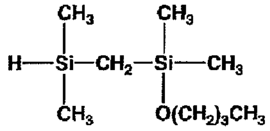
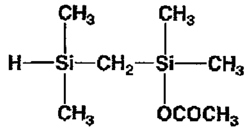
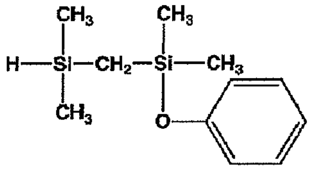
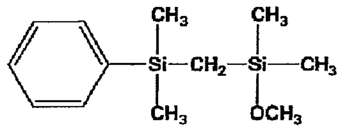
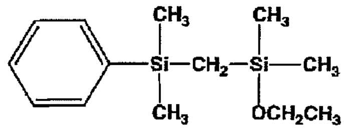
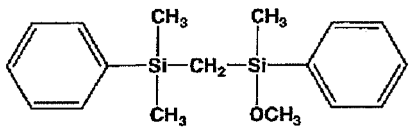
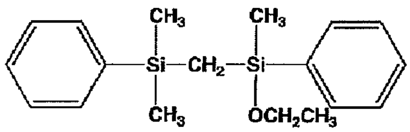
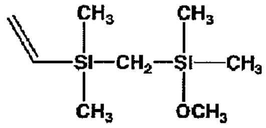
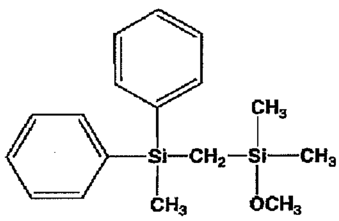
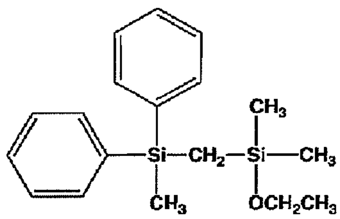
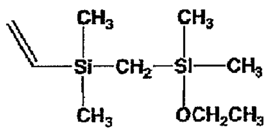
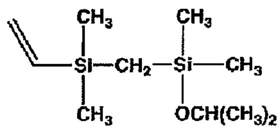
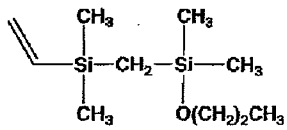
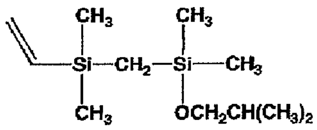
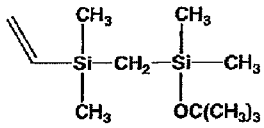
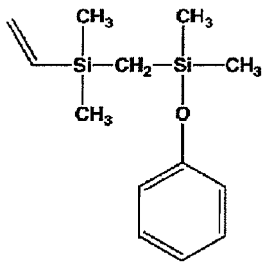
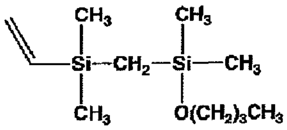
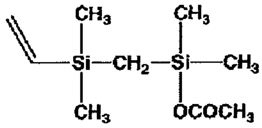

Examples of the organosilane compounds shown by the general formula (1) in which n=1 and m=2 include the following compounds.

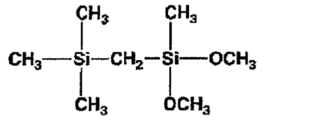
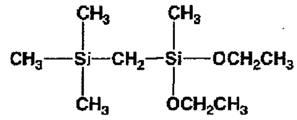
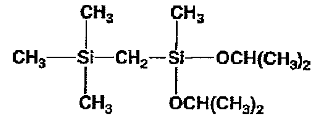
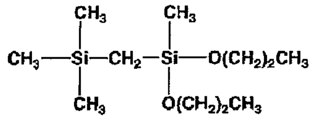
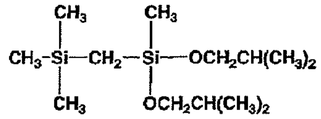
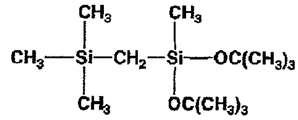
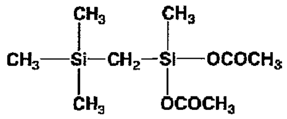
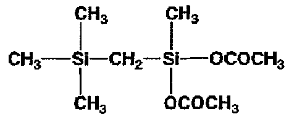
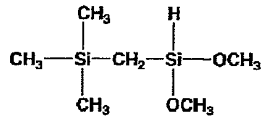
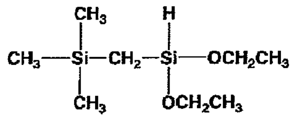
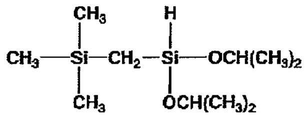
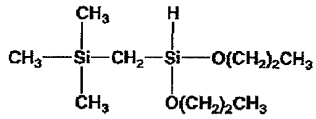
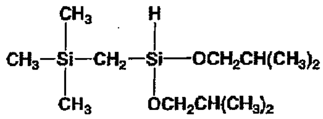
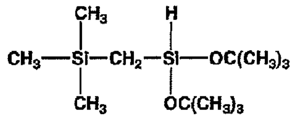
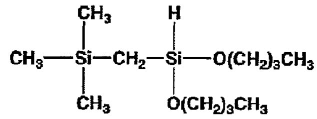

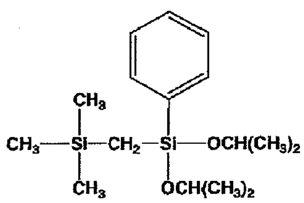
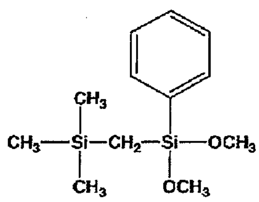
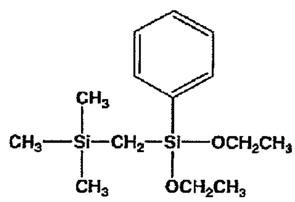
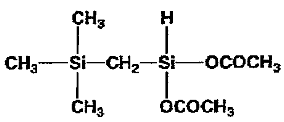
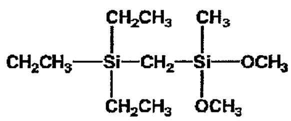
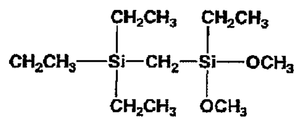

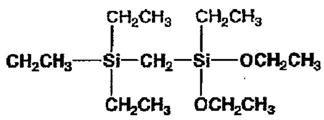
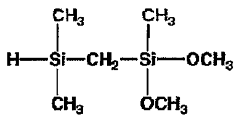
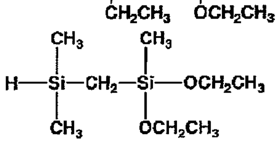
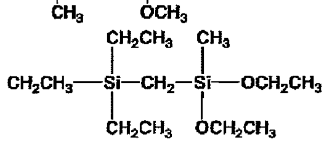

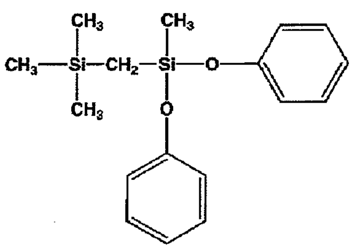
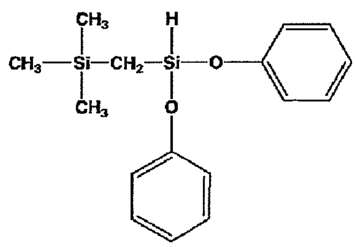

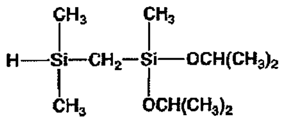 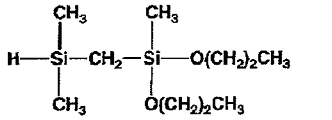 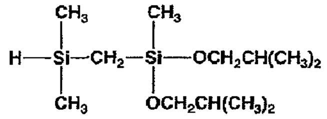

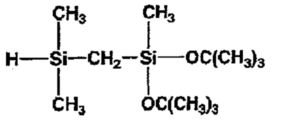 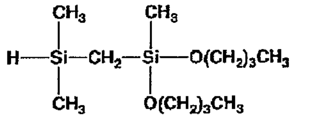 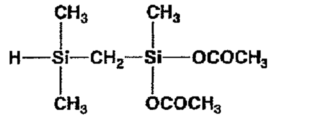

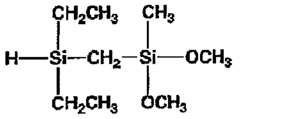 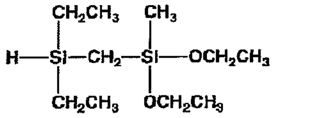 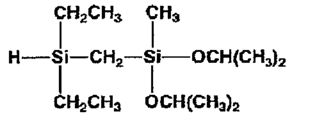

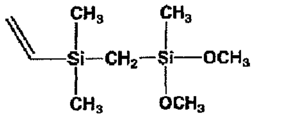 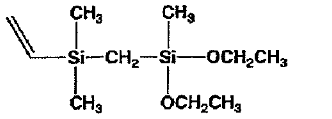 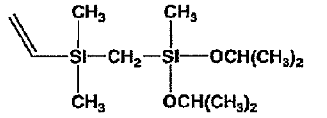

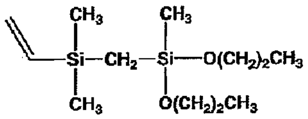 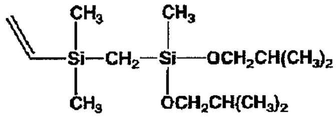 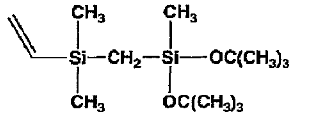

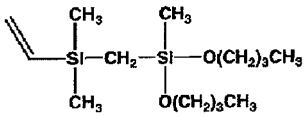 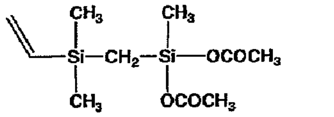 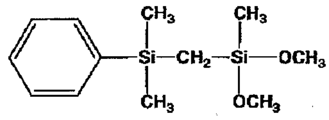

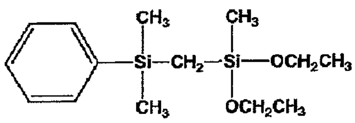 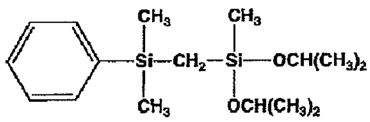

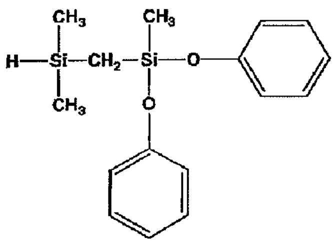 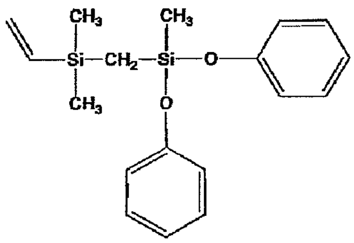

Examples of the organosilane compounds shown by the general formula (1) in which n=2 and m=1 include the following compounds.

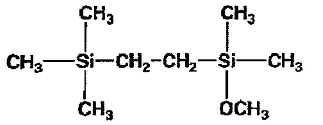
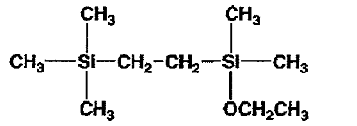
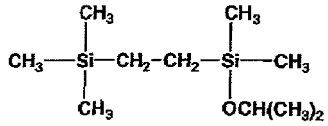
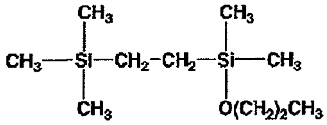
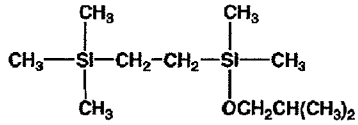
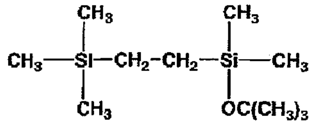
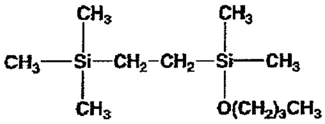
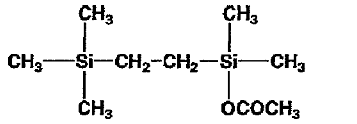
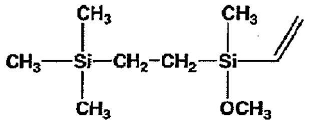
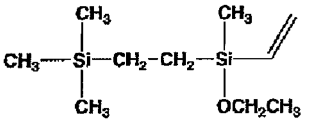
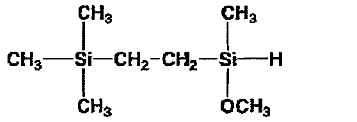
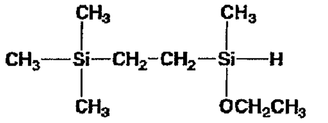

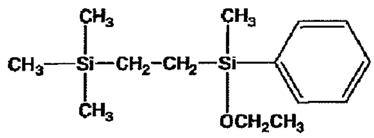
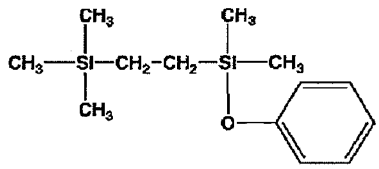

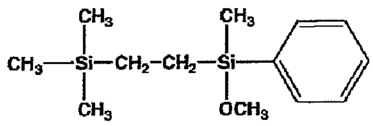

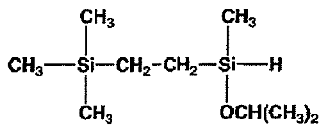
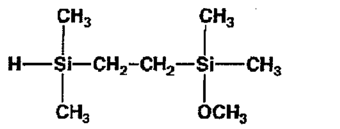
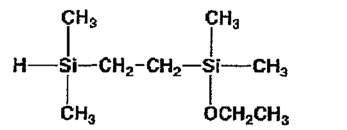
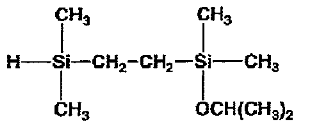
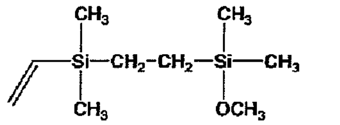
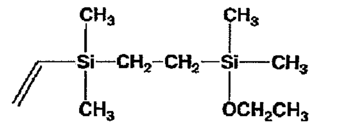
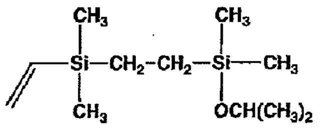
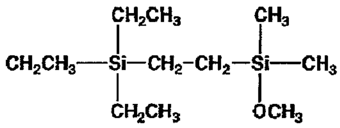
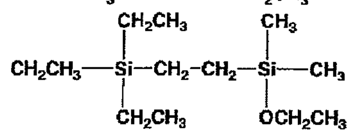
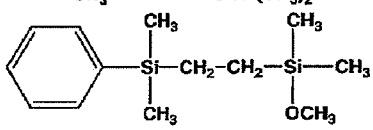
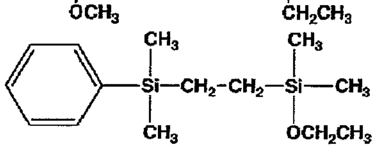

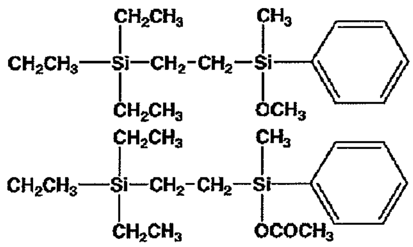

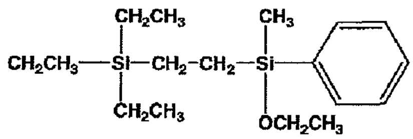

Examples of the organosilane compounds shown by the general formula (1) in which n=2 and m=2 include the following compounds.

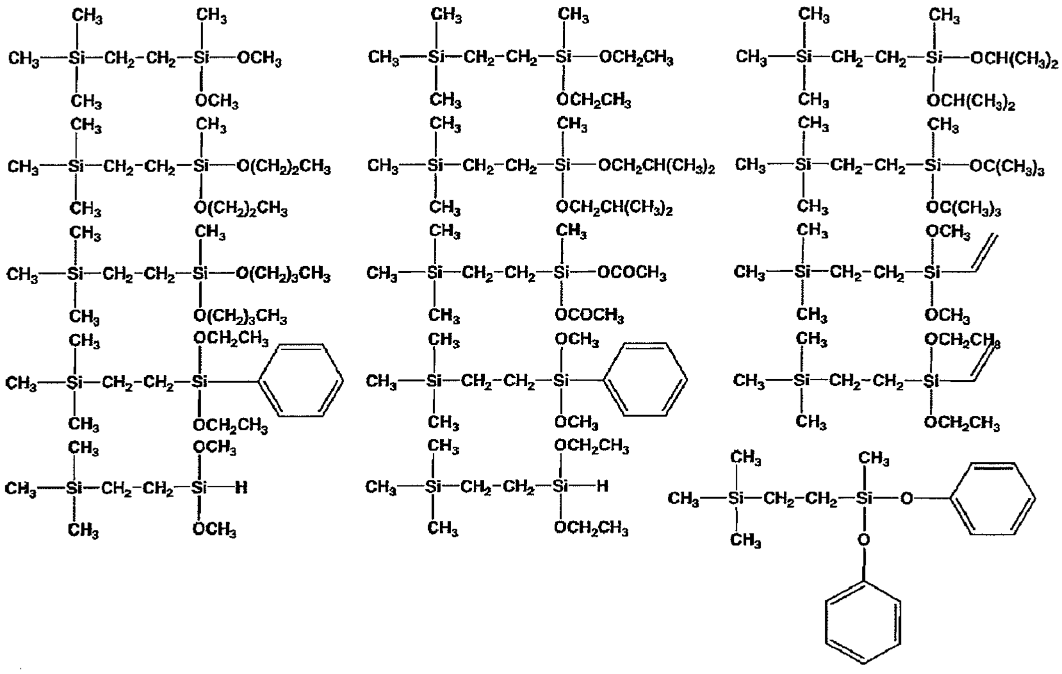

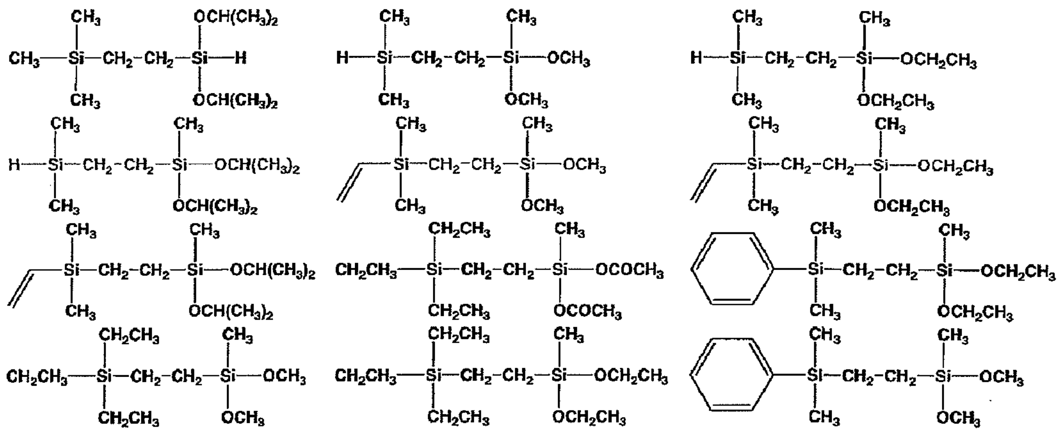

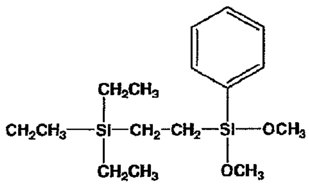
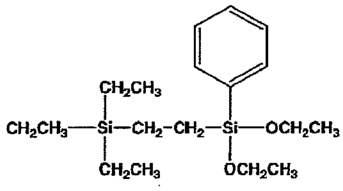
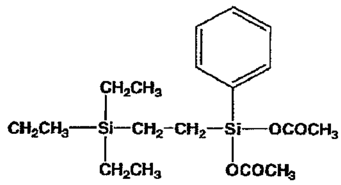

Examples of the organosilane compounds shown by the general formula (1) in which n=3 and m=1 include the following compounds.

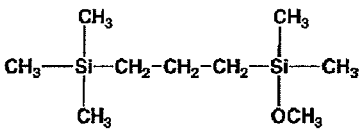
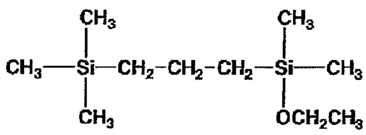
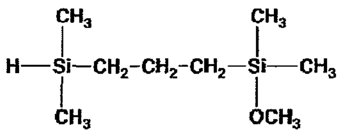
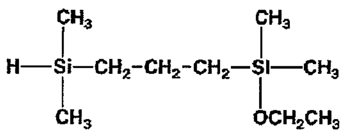
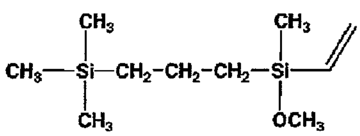
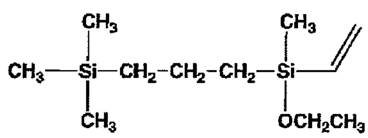
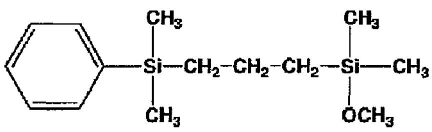
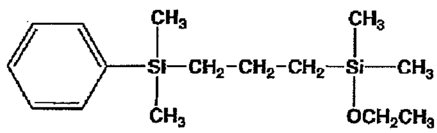
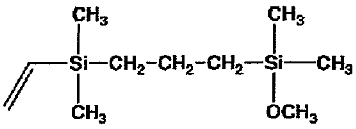
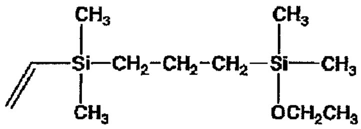

Examples of the organosilane compounds shown by the general formula (1) in which n=3 and m=2 include the following compounds.

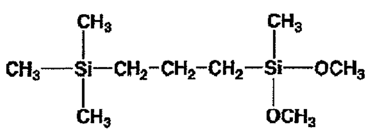
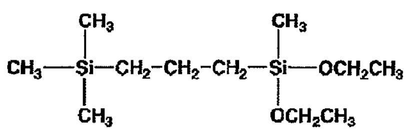
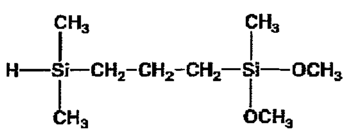
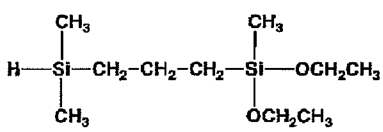

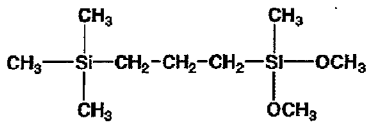

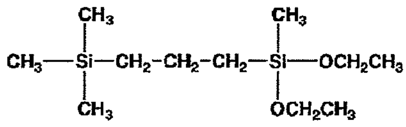

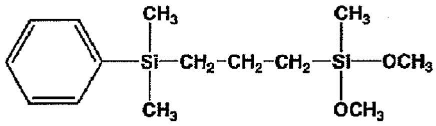

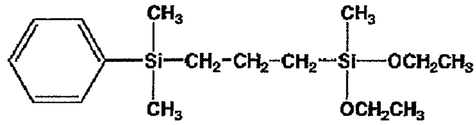

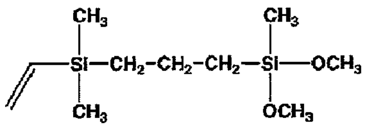

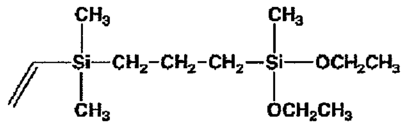

In the organosilane compound shown by the general formula (1), it is preferable that the total number of hydrogen atoms included in $R^1$ to $R^4$ be 0 to 2, and more preferably 0 or 1, from the viewpoint of ease of synthesis and purification and handling capability.

In the organosilane compound shown by the general formula (1), it is preferable that m be one or two, and more preferably one, from the viewpoint of the mechanical strength of the silicon-containing film.

It is preferable that the silicon-containing film-forming material according to this embodiment mainly include the organosilane compound shown by the general formula (1). Note that the silicon-containing film-forming material according to this embodiment may include components other than the organosilane compound shown by the general formula (1). It is preferable that the silicon-containing film-forming material according to this embodiment include the organosilane compound shown by the general formula (1) in an amount of 30 to 100%, more preferably 60 to 100%, and particularly preferably 90 to 100%.

The silicon-containing film-forming material according to this embodiment may be used to form an insulating film that includes silicon, carbon, oxygen, and hydrogen. Such an insulating film has high resistance to a hydrofluoric acid-based chemical widely used for a washing step during a semiconductor production process (i.e., high process resistance).

When using the silicon-containing film-forming material according to this embodiment that includes the organosilane compound shown by the general formula (1) as an insulating film-forming material, it is preferable that the silicon-containing film-forming material have a content of elements (hereinafter may be referred to as "impurities") other than silicon, carbon, oxygen, and hydrogen of less than 10 ppb and a water content of less than 100 ppm. An insulating film that has a low relative dielectric constant and excellent process resistance can be obtained at high yield by forming an insulating film using such an insulating film-forming material.

1.2. Method of producing organosilane compound

A method of producing the organosilane compound shown by the general formula (1) is not particularly limited. For example, a method that subjects an organosilane compound shown by the following general formula (2) and an organosilane compound shown by the following general formula (3) to undergo a coupling reaction in the presence of a metal may be used. As the metal, magnesium is normally used.

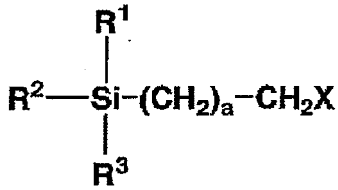

(2)

wherein $R^1$ to $R^3$ individually represent a hydrogen atom, an alkyl group having 1 to 4 carbon atoms, a vinyl group, or a phenyl group, X represents a halogen atom, and a represents an integer from 0 to 2.

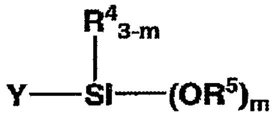

(3)

wherein $R^4$ individually represents a hydrogen atom, an alkyl group having 1 to 4 carbon atoms, a vinyl group, or a phenyl group, $R^5$ represents an alkyl group having 1 to 4 carbon atoms, an acetyl group, or a phenyl group, Y represents a halogen atom, a hydrogen atom, or an alkoxy group, and m represents 1 or 2.

Examples of the alkyl group having 1 to 4 carbon atoms represented by $R^1$ to $R^5$ in the general formulas (2) and (3) include the alkyl groups having 1 to 4 carbon atoms mentioned for $R^1$ to $R^5$ in the general formula (1). Examples of the halogen atom represented by X and Y include a bromine atom and a chlorine atom. Examples of the alkoxy group represented by Y include the alkoxy group shown by $-OR^5$ in the general formula (1).

2. Method of forming silicon-containing film

A method of forming a silicon-containing film (insulating film) according to one embodiment of the invention is preferably carried out by chemical vapor deposition (CVD), and particularly preferably plasma-enhanced CVD (PECVD). Specifically, the organosilane compound shown by the general formula (1) is vaporized in a PECVD device using a vaporizer and introduced into a deposition chamber. Plasma is generated by applying a voltage to electrodes provided in the deposition chamber from a high-frequency power supply to form a plasma CVD film on a substrate disposed in the deposition chamber.

Examples of the substrate on which the silicon-containing film according to this embodiment is formed include Si-containing layers formed of Si, $SiO_2$, SiN, SiC, SiCN, and the like. Gas such as argon or helium and an oxidizing agent such as oxygen or nitrous oxide may be introduced into the deposition chamber in order to generate plasma. A thin film (deposited film) suitable as a low-dielectric-constant material for semiconductor devices can be formed by depositing a film using the silicon-containing film-forming material according to this embodiment utilizing the PECVD device.

A plasma generation method using the PECVD device is not particularly limited. For example, inductively-coupled plasma, capacitively-coupled plasma, ECR plasma, or the like may be used.

It is preferable that the silicon-containing deposited film thus obtained have a thickness of 0.05 to 5.0 micrometers. The deposited film is then cured to form a silicon-containing film (insulating film).

The deposited film may be cured by at least one means selected from heating, electron beam irradiation, ultraviolet irradiation, and oxygen plasma application.

When curing the deposited film by heating, the deposited film formed by CVD is heated to 80 to 450°C in an inert atmosphere or under reduced pressure, for example. The deposited film may be heated using a hot plate, an oven, a furnace, or the like. The heating atmosphere may be an inert atmosphere or an atmosphere under reduced pressure.

In order to control the curing speed of the deposited film, the deposited film may be heated stepwise, or the atmosphere may be selected from nitrogen, air, oxygen, and an atmosphere under reduced pressure, if necessary. A silicon-containing film can be formed by the above-described steps.

3. Silicon-containing film

A silicon-containing film according to one embodiment of the invention may be obtained by the above-described film-forming method.

Since the silicon-containing film according to this embodiment has a low dielectric constant and excellent surface flatness, the silicon-containing film is particularly useful for an interlayer dielectric for semiconductor devices such as an LSI, a system LSI, a DRAM, an SDRAM, an RDRAM, and a D-RDRAM. The silicon-containing film may also be suitably used as an etching stopper film, a protective film (e.g., surface coating film) for semiconductor devices, an intermediate layer used in a semiconductor production process utilizing a multilayer resist, an interlayer dielectric for multilayered wiring boards, a protective film and an insulating film for liquid crystal display devices, and the like. The silicon-containing film according to this embodiment is also suitable for semiconductor devices formed using a copper damascene process, for example.

Since the silicon-containing film according to this embodiment is formed using the above-mentioned silicon-containing film-forming material, the silicon-containing film includes an $-Si-(CH_2)_n-Si-O-$ site (wherein n represents an integer from 1 to 3). Since the silicon-containing film according to this embodiment that includes the $-Si-(CH_2)_n-Si-O-$ site has excellent chemical resistance and suppresses an increase in relative dielectric constant during a production process, the silicon-containing film has a low relative dielectric constant and excellent process resistance. The silicon-containing film according to this embodiment preferably has a relative dielectric constant of 3.0 or less, more preferably 1.8 to 3.0, and still more preferably 2.2 to 3.0.

The silicon-containing film according to this embodiment preferably has a modulus of elasticity of 4.0 to 15.0 GPa, and more preferably 4.0 to 12.0 GPa. The silicon-containing film according to this embodiment preferably has a hardness of 0.1 GPa or more, and more preferably 0.5 GPa or more. Therefore, the silicon-containing film according to this embodiment has excellent insulating film properties (e.g., mechanical strength and relative dielectric constant).

4. Examples

The invention is further described below by way of examples. Note that the invention is not limited to the following examples. In the examples and comparative examples, the units "part" and "%" respectively refer to "part by weight" and "wt%" unless otherwise indicated.

4.1. Evaluation method

Various properties were evaluated as follows.

4.1.1. Impurity content of organosilane compound

The water content and the impurity content of a purified organosilane compound were measured using a Karl Fisher aquacounter ("AQ-7" manufactured by Hiranuma Sangyo Co., Ltd.) and an atomic absorption spectrophotometer (polarized Zeeman atomic absorption spectrophotometer "Z-5700" manufactured by Hitachi High-Technologies Corporation).

4.1.2. Relative dielectric constant

A silicon-containing insulating film was formed on an eight-inch silicon wafer by PECVD under conditions described later. An aluminum electrode pattern was formed on the resulting film by a deposition method to prepare a relative dielectric constant measurement sample. The relative dielectric constant of the sample (insulating film) was measured by a CV method at a frequency of 100 kHz using an electrode "HP16451B" and a precision LCR meter "HP4284A" manufactured by Yokogawa Hewlett-Packard. The difference between the relative dielectric constant (k@RT) measured at a temperature of 24°C and a relative humidity of 40%RH and the relative dielectric constant (k@200°C) measured at a temperature of 200°Cin a dry nitrogen atmosphere is referred to as deltak (deltak=k@RT-k@200°C). An increase in relative dielectric constant due to moisture absorption of the film can be evaluated based on the difference deltak. An organic silica film having a difference deltak of 0.15 or more is generally considered to have high moisture absorption properties.

4.1.3. Hardness and modulus of elasticity (Young's modulus) of insulating film

A Berkovich indenter was installed in a nanohardness tester ("Nanoindenter XP" manufactured by MTS), and the universal hardness of the resulting insulating film was measured. The modulus of elasticity was measured using a

continuous stiffness measurement method.

4.1.4. Storage stability

The purity of an organosilane compound stored at 40°C for 30 days was measured by GC (instrument: "6890N" manufactured by Agilent Technologies, column: "SPB-35" manufactured by Supelco). When a change in purity due to storage was less than 0.5 % , the storage stability was evaluated as good.

4.1.5. Chemical resistance

An eight-inch wafer on which a silicon-containing insulating film was formed was immersed in a 0.2% diluted hydrofluoric acid aqueous solution at room temperature for three minutes to observe a change in thickness of the silicon-containing insulating film due to immersion. The chemical resistance was evaluated as good when the residual film rate defined below was 99 % or more.

$$\text{Residual film rate (\%)} = \text{(thickness after immersion)} / \text{(thickness before immersion)} \times 100$$

A: The residual film rate was 99% or more.
B: The residual film rate was less than 99%.

4.2. Production of film-forming material

4.2.1. Synthesis Example 1

A three-necked flask equipped with a cooling condenser and a dropping funnel was dried at 50°C under reduced pressure, and was charged with nitrogen. After the addition of 20 g of magnesium and 500 ml of THF to the flask, 25 g of (chloromethyl)trimethylsilane was added to the mixture with stirring at room temperature. After continuously stirring the mixture to confirm generation of heat, 55 g of (chloromethyl)trimethylsilane was added to the mixture from the dropping funnel over 30 minutes. After the addition, the mixture was allowed to cool to room temperature. A mixed liquid of 250 ml of THF and 237 g of methyltrimethoxysilane was then added to the flask. The mixture was then refluxed with heating at 70°C for six hours to complete the reaction. After cooling the reaction liquid to room temperature, magnesium salts produced and unreacted magnesium were filtered out. The filtrate was then fractionated to obtain 75 g of [(trimethylsilyl)methyl]methyldimethoxysilane (yield: 60%). The purity of the resulting [(trimethylsilyl)methyl]methyldimethoxysilane determined by GC was 99.4%. The residual water content was 80 ppm. The content (metal impurity content) of elements other than silicon, carbon, oxygen, and hydrogen was as follows. Specifically, the Na content was 1.4 ppb, the K content was 1.0 ppb, and the Fe content was 1.8 ppb. The content of Li, Mg, Cr, Ag, Cu, Zn, Mn, Co, Ni, Ti, Zr, Al, Pb, Sn, and W was equal to or less than the detection limit (0.2 ppb). It was confirmed that the organosilane compound obtained by Synthesis Example 1 had a purity sufficient for an insulating film-forming material.

4.2.2. Synthesis Example 2

A three-necked flask equipped with a cooling condenser and a dropping funnel was dried at 50°C under reduced pressure, and was charged with nitrogen. After the addition of 20 g of magnesium and 500 ml of THF to the flask, 25 g of (chloromethyl)trimethylsilane was added to the mixture with stirring at room temperature. After continuously stirring the mixture to confirm generation of heat, 55 g of (chloromethyl)trimethylsilane was added to the mixture from the dropping funnel over 30 minutes. After the addition, the mixture was allowed to cool to room temperature. A mixed liquid of 250 ml of THF and 258 g of vinyltrimethoxysilane was then added to the flask. The mixture was then refluxed with heating at 70°C for six hours to complete the reaction. After cooling the reaction liquid to room temperature, magnesium salts produced and unreacted magnesium were filtered out. The filtrate was then fractionated to obtain 80 g of [(trimethylsilyl)methyl]vinyldimethoxysilane (yield: 60%). The purity of the resulting [(trimethylsilyl)methyl]vinyldimethoxysilane determined by GC was 99.1 %. The residual water content was 80 ppm. The content (metal impurity content) of elements other than silicon, carbon, oxygen, and hydrogen was as follows. Specifically, the Na content was 1.1 ppb, the K content was 1.3 ppb, and the Fe content was 1.5 ppb. The content of Li, Mg, Cr, Ag, Cu, Zn, Mn, Co, Ni, Ti, Zr, Al, Pb, Sn, and W was equal to or less than the detection limit (0.2 ppb). It was confirmed that the organosilane compound obtained by

Synthesis Example 2 had a purity sufficient for an insulating film-forming material.

4.2.3. Synthesis Example 3

A three-necked flask equipped with a cooling condenser and a dropping funnel was dried at 50°C under reduced pressure, and was charged with nitrogen. After the addition of 500 ml of toluene to the flask, 129 g of ethyldichlorosilane and 142 g of vinyltriethylsilane were added to the flask with stirring at room temperature. After continuously stirring the mixture, 100 mg of chloroplatinic acid was added to the mixture. The mixture was then allowed to react at 100°C for five hours. After cooling the mixture to room temperature, 160 g of pyridine was added to the mixture. 100 g of ethanol was then added dropwise to the mixture with stirring. After the addition, the mixture was allowed to react at room temperature for three hours. Then, salts produced were filtered out, and the filtrate was fractionated to obtain 180 g of [(triethylsilyl)ethyl]ethyldiethoxysilane (yield: 62%). The purity of the resulting [(triethylsilyl)ethyl]ethyldiethoxysilane determined by GC was 99.2%. The residual water content was 30 ppm. The content (metal impurity content) of elements other than silicon, carbon, oxygen, and hydrogen was as follows. Specifically, the Na content was 1.1 ppb, the K content was 1.5 ppb, and the Fe content was 1.9 ppb. The content of Li, Mg, Cr, Ag, Cu, Zn, Mn, Co, Ni, Ti, Zr, Al, Pb, Sn, and W was equal to or less than the detection limit (0.2 ppb). It was confirmed that the organosilane compound obtained by Synthesis Example 3 had a purity sufficient for an insulating film-forming material.

4.3. Film formation

4.3.1. Example 1

A silicon-containing film (1-1) (thickness: 500 nm) was deposited on a silicon substrate by plasma CVD using a plasma CVD device "PD-220N" (manufactured by SAMCO, Inc.) at a [(trimethylsilyl)methyl]methyldimethoxysilane gas flow rate of 25 sccm, an Ar gas flow rate of 3 sccm, an RF power of 250 W, a substrate temperature of 380°C, and a reaction pressure of 10 Torr.

4.3.2. Example 2

A silicon-containing film (1-2) (thickness: 500 nm) was deposited on a silicon substrate in the same manner as in Example 1, except that [(trimethylsilyl)methyl]vinyldimethoxysilane was used as a silica source.

4.3.3. Example 3

A silicon-containing film (1-3) (thickness: 500 nm) was deposited on a silicon substrate in the same manner as in Example 1, except that [(triethylsilyl)ethyl]ethyldiethoxysilane was used as a silica source.

4.3.2. Comparative Example 1

A silicon-containing film (2) (thickness: 500 nm) was deposited on a silicon substrate in the same manner as in Example 1, except that dimethoxydimethylsilane was used as a silica source.

4.3.2. Comparative Example 2

A silicon-containing film (2-2) (thickness: 500 nm) was deposited on a silicon substrate in the same manner as in Example 1, except that divinyldimethoxysilane was used as a silica source.

4.3.3. Comparative Example 3

A silicon-containing film (2-3) (thickness: 500 nm) was deposited on a silicon substrate in the same manner as in Example 1, except that 1,2-bis(triethoxysilyl)ethane was used as a silica source.

Table 1 shows the evaluation results for the silicon-containing films obtained in Example 1 and Comparative Example 1.

TABLE 1

| | Relative dielectric constant | Deltak | Hardness (GPa) | Modulus of elasticity (GPa) | Storage stability | Chemical resistance |
|---|---|---|---|---|---|---|
| Example 1 | 2.45 | 0.12 | 0.8 | 8.5 | Good | A |
| Example 2 | 2.47 | 0.13 | 0.9 | 9.1 | Good | A |
| Example 3 | 2.43 | 0.11 | 0.8 | 8.6 | Good | A |
| Comparative Example 1 | 2.55 | 0.17 | 0.7 | 7.7 | Good | B |
| Comparative Example 2 | 2.50 | 0.18 | 0.7 | 7.5 | Good | B |
| Comparative Example 3 | 2.51 | 0.20 | 0.6 | 6.9 | Good | B |

The silicon-containing films obtained in Examples 1 to 3 had excellent mechanical strength, a low difference Deltak (i.e., an index of relative dielectric constant and hygroscopicity), excellent chemical resistance, and excellent storage stability. On the other hand, the films obtained in Comparative Examples 1 to 3 had low mechanical strength, a high relative dielectric constant, a high difference Deltak, and low chemical resistance as compared with the films obtained in Examples 1 to 3.

As described above, since the silicon-containing film according to the invention has excellent mechanical strength, a low relative dielectric constant, excellent hygroscopic resistance, excellent chemical resistance, and excellent storage stability, the silicon-containing film according to the invention can be suitably used as an interlayer dielectric of semiconductor devices and the like.

## Claims

1. A silicon-containing film-forming material comprising an organosilane compound shown by the following general formula (1),

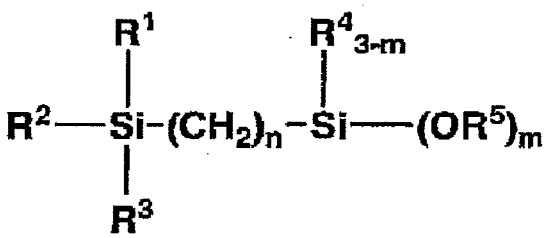

(1)

wherein $R^1$ to $R^4$ individually represent a hydrogen atom, an alkyl group having 1 to 4 carbon atoms, a vinyl group, or a phenyl group, $R^5$ represents an alkyl group having 1 to 4 carbon atoms, an acetyl group, or a phenyl group, n represents an integer from 1 to 3, and m represents 1 or 2.

2. The silicon-containing film-forming material according to claim 1, the material being used to form an insulating film that includes silicon, carbon, oxygen, and hydrogen.

3. The silicon-containing film-forming material according to claim 1 or 2, the material having a content of elements other than silicon, carbon, oxygen, and hydrogen of less than 10 ppb, and a water content of less than 100 ppm.

4. A silicon-containing insulating film formed by using the silicon-containing film-forming material according to any one

of claims 1 to 3.

5. The silicon-containing insulating film according to claim 4, the film being formed by chemical vapor deposition.

6. A method of forming a silicon-containing insulating film, the method comprising:

   depositing the silicon-containing film-forming material according to any one of claims 1 to 3 on a substrate by chemical vapor deposition to form a deposited film; and
   curing the deposited film by at least one means selected from heating, electron beam irradiation, ultraviolet irradiation, and oxygen plasma application.

7. A silicon-containing insulating film obtained by the method of forming a silicon-containing insulating film according to claim 6.

8. The silicon-containing insulating film according to any one of claims 4, 5, and 7, the film including an $-Si-(CH_2)_n-Si-O-$ site (wherein n represents an integer from 1 to 3).

9. The silicon-containing insulating film according to any one of claims 4, 5, 7, and 8, the film having a dielectric constant of 3.0 or less.

**INTERNATIONAL SEARCH REPORT**

International application No.
PCT/JP2007/065857

A. CLASSIFICATION OF SUBJECT MATTER
*C09D183/00*(2006.01)i, *C23C16/06*(2006.01)i, *H01L21/312*(2006.01)i

According to International Patent Classification (IPC) or to both national classification and IPC

B. FIELDS SEARCHED

Minimum documentation searched (classification system followed by classification symbols)
C09D183/00, C23C16/06, H01L21/312

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)
CAplus, REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>Y | JP 03-024093 A (Shin-Etsu Chemical Co., Ltd.), 01 February, 1991 (01.02.91), Claims; page 1, lower right column, lines 6 to 17; page 3, lower left column, lines 9 to 14; page 3, lower right column, line 3 to page 4, upper right column, line 2; example 1 (Family: none) | 1<br>2-9 |
| X<br>Y | JP 2005-019980 A (Air Products and Chemicals, Inc.), 20 January, 2005 (20.01.05), Claims; Par. Nos. [0052], [0068], [0076] to [0083], [0086] to [0089] & EP 1482070 A1 & US 2004/0241463 A1 & KR 2004104402 A & CN 1576390 A & TW 200426239 A | 1,2,4-9<br>3 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 16 October, 2007 (16.10.07) | 30 October, 2007 (30.10.07) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2007/065857

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2005-350653 A (JSR Corp.), 22 December, 2005 (22.12.05), Claims; Par. Nos. [0036] to [0042], [0117] to [0125] & WO 2005/068540 A1 & EP 1705208 A1 & US 2007/0020467 A1 & KR 2006123547 A | 2-9 |
| P,A | JP 2007-254594 A (JSR Corp.), 04 October, 2007 (04.10.07), Claims (Family: none) | 1-9 |
| P,A | JP 2007-254597 A (JSR Corp.), 04 October, 2007 (04.10.07), Claims (Family: none) | 1-9 |
| P,A | JP 2007-262255 A (JSR Corp.), 11 October, 2007 (11.10.07), Claims (Family: none) | 1-9 |
| P,A | JP 2007-262257 A (JSR Corp.), 11 October, 2007 (11.10.07), Claims (Family: none) | 1-9 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 11288931 A
- JP 2002329718 A
- JP 2002503879 T
- JP 2005513766 T
- JP 2004006607 A
- JP 2005051192 A